# EUROPEAN PATENT APPLICATION

(11) **EP 4 848 906 A1**
(43) Date of publication of application: **02.12.2026**
(21) Application number: 26182002.1
(22) Date of filing: 29.05.2026
(51) Int. Cl.: H05K 1/02, G02B 6/42, H10H 29/80, H05K 1/18, G02B 13/00, G02B 19/00, H10H 20/857

(54) **OPTOELECTRONIC SEMICONDUCTOR DEVICE AND OPTOELECTRONIC SEMICONDUCTOR DEVICE ASSEMBLY INCLUDING THE SAME**

(30) Priority: 29.05.2025 US 202563813646 P
(71) Applicant: Seoul Semiconductor Co., Ltd., Gyeonggi-do 15429 (KR)
(72) Inventor: Cho, HongSeok, 15429 Ansan-si, Gyeonggi-do (KR)
(74) Representative: Stolmár & Partner Patentanwälte PartG mbB

(57) **Abstract**

According to an aspect of the present disclosure, an optoelectronic semiconductor device assembly may be provided, including: an optoelectronic semiconductor device; and a power supply configured to supply power to the optoelectronic semiconductor device, wherein the optoelectronic semiconductor device comprises: a circuit board electrically connected to the power supply; a light emitting element disposed on the circuit board and electrically connected to the power supply through the circuit board, the light emitting element being configured to generate light when a predetermined light emitting element driving voltage is applied to the light emitting element through the circuit board; and an auxiliary element electrically connected to the circuit board and configured to be applied with a predetermined auxiliary element applied voltage from the power supply through the circuit board when the light emitting element driving voltage is applied to the light emitting element by the power supply, wherein the light emitting element driving voltage is greater than the auxiliary element applied voltage.

## Description

### TECHNICAL FIELD

The present disclosure relates to an optoelectronic semiconductor device and an optoelectronic semiconductor device assembly including the same.

### BACKGROUND OF THE INVENTION

Recently, a light emitting diode (LED) is widely used. A light emitting diode utilizes characteristics of a compound semiconductor to convert an electrical signal into light such as infrared light, visible light, or ultraviolet light.

As luminous efficiency of the light emitting diode increases, the light emitting element is applied to various fields including a display device, a lighting device, a vehicle, and the like.

Recently, there is a demand for development of technology for reducing costs and increasing power efficiency by miniaturizing an optoelectronic semiconductor device.

### SUMMARY OF THE INVENTION

Embodiments of the present disclosure provide an optoelectronic semiconductor device and an optoelectronic semiconductor device assembly including the same, which can include a miniaturized circuit board and a miniaturized refractor.

Embodiments of the present disclosure provide an optoelectronic semiconductor device and an optoelectronic semiconductor device assembly including the same, which can improve power efficiency and luminous efficiency by using a high-voltage optoelectronic semiconductor device assembly.

Embodiments of the present disclosure provide an optoelectronic semiconductor device and an optoelectronic semiconductor device assembly including the same, which can reduce use of an unnecessary resistance element by reducing a difference value between an optoelectronic semiconductor device assembly driving voltage and a light emitting element driving voltage.

Embodiments of the present disclosure provide an optoelectronic semiconductor device and an optoelectronic semiconductor device assembly including the same, which can uniformly emit light by using a plurality of light emitting cells.

Embodiments of the present disclosure provide an optoelectronic semiconductor device and an optoelectronic semiconductor device assembly including the same, which can adjust a viewing angle by using a refractor.

According to an aspect of the present disclosure, an optoelectronic semiconductor device assembly is provided, including: an optoelectronic semiconductor device; and a power supply configured to supply power to the optoelectronic semiconductor device, wherein the optoelectronic semiconductor device comprises: a circuit board electrically connected to the power supply; a light emitting element disposed on the circuit board and electrically connected to the power supply through the circuit board, the light emitting element being configured to generate light when a predetermined light emitting element driving voltage is applied to the light emitting element through the circuit board; and an auxiliary element electrically connected to the circuit board and configured to be applied with a predetermined auxiliary element applied voltage from the power supply through the circuit board when the light emitting element driving voltage is applied to the light emitting element by the power supply, wherein the light emitting element driving voltage is greater than the auxiliary element applied voltage.

Furthermore, the optoelectronic semiconductor device assembly is provided, wherein when the light emitting element driving voltage is applied to the light emitting element, a driving voltage applied from an external source to drive the optoelectronic semiconductor device is defined as an optoelectronic semiconductor device driving voltage, and a difference between the optoelectronic semiconductor device driving voltage and the light emitting element driving voltage is equal to or greater than 0.1 times the optoelectronic semiconductor device driving voltage and equal to or less than 0.5 times the optoelectronic semiconductor device driving voltage.

Furthermore, the optoelectronic semiconductor device assembly is provided, wherein the optoelectronic semiconductor device driving voltage ranges from 12 V to 18 V.

Furthermore, the optoelectronic semiconductor device assembly is provided, wherein, when the light emitting element driving voltage is applied, a current ranging from 10 mA to 50 mA flows through the light emitting element.

Furthermore, the optoelectronic semiconductor device assembly is provided, wherein the light emitting element has a luminous efficiency ranging from 100 lm/W to 200 Im/W.

Furthermore, the optoelectronic semiconductor device assembly is provided, wherein the light emitting element comprises a plurality of light emitting cells, and the plurality of light emitting cells are connected in series.

Furthermore, the optoelectronic semiconductor device assembly is provided, wherein separation grooves are, respectively, formed between adjacent ones of the plurality of light emitting cells to separate the adjacent ones
Furthermore, the optoelectronic semiconductor device assembly is provided, wherein a total number of electrodes of the light emitting element is greater than a total number of electrodes of the circuit board connected with the light emitting element.

Furthermore, the optoelectronic semiconductor device assembly is provided, wherein the plurality of light emitting cells comprise: a first light emitting cell; a second light emitting cell electrically connected to the first light emitting cell through a first connection electrode; a third light emitting cell electrically connected to the second light emitting cell through a second connection electrode; and a fourth light emitting cell electrically connected to the third light emitting cell through a third connection electrode.

Furthermore, the optoelectronic semiconductor device assembly is provided, wherein the first light emitting cell and the fourth light emitting cell are electrically connected to the power supply.

Furthermore, the optoelectronic semiconductor device assembly is provided, wherein the light emitting element comprises: a base substrate; a light emitting diode configured to generate light; and a first reflection layer extending upward from an edge of the base substrate.

Furthermore, the optoelectronic semiconductor device assembly is provided, wherein a height of the first reflection layer is equal to or greater than a height of the light emitting diode.

Furthermore, the optoelectronic semiconductor device assembly is provided, wherein the light emitting element further comprises a second reflection layer in contact with a side surface of the light emitting diode, and a reflectance of the second reflection layer is greater than that of the first reflection layer.

Furthermore, the optoelectronic semiconductor device assembly is provided, wherein the second reflection layer comprises at least one of silicone, alumina (Al₂O₃), titanium dioxide (TiO₂), and barium sulfate (BaSO₄).

Furthermore, the optoelectronic semiconductor device assembly is provided, wherein the base substrate is configured to reflect a portion of the light generated from the light emitting element.

Embodiments of the present disclosure may reduce manufacturing costs by using a miniaturized circuit board and a miniaturized refractor.

Furthermore, embodiments of the present disclosure may improve power efficiency and luminous efficiency by using a high-voltage light emitting element.

Furthermore, embodiments of the present disclosure may reduce use of an unnecessary resistance element by reducing a difference value between an optoelectronic semiconductor device assembly driving voltage and a light emitting element driving voltage.

Furthermore, embodiments of the present disclosure may improve reliability by reducing use of an unnecessary heat-generating element.

Furthermore, embodiments of the present disclosure may uniformly emit light by using a plurality of light emitting cells.

Furthermore, embodiments of the present disclosure may adjust a viewing angle by using a refractor having an inclined surface formed thereon.

### BRIEF DESCRIPTION OF THE DRAWINGS

FIG. 1 is a conceptual diagram illustrating an optoelectronic semiconductor device assembly according to a first embodiment.
FIG. 2 is a perspective view illustrating an optoelectronic semiconductor device according to the first embodiment.
FIG. 3 is an exploded perspective view illustrating the optoelectronic semiconductor device according to the first embodiment.
FIG. 4 is a cross-sectional view taken along line IV-VI illustrating a light emitting element according to the first embodiment.
FIG. 5 is a cross-sectional view taken along line V-V illustrating a light emitting diode according to the first embodiment.
FIG. 6 is a cross-sectional view taken along line VI-VI illustrating the light emitting diode of FIG. 5.
FIG. 7 is a circuit diagram according to the first embodiment.
FIG. 8 is a partial side view illustrating the optoelectronic semiconductor device according to the first embodiment.

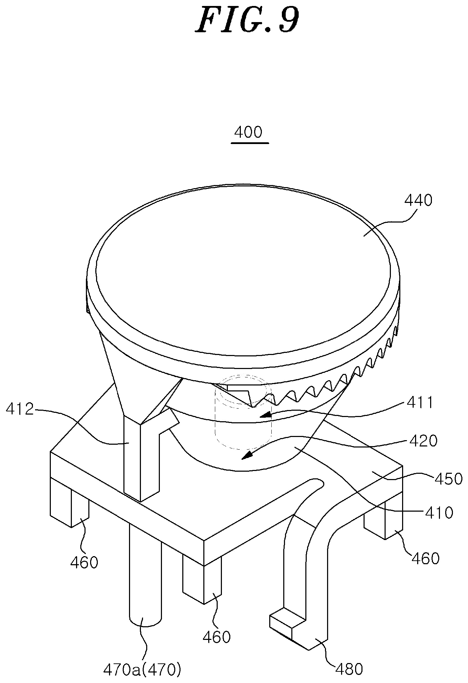

FIG. 9 is a perspective view illustrating a refractor included in the optoelectronic semiconductor device according to the first embodiment.
FIG. 10 is a perspective view illustrating a lower side of the refractor of FIG. 9.

### DETAILED DESCRIPTION OF THE INVENTION

In the following description, for the purpose of description, numerous specific details are set forth to provide a thorough understanding of various embodiments or implementations of the present disclosure. As used herein, "embodiment" and "implementation" are interchangeable terms representing non-limiting examples of devices or methods utilizing one or more of the concepts of the present disclosure. However, various embodiments may obviously be practiced without utilizing these specific details or by utilizing one or more equivalent configurations. In other instances, well-known structures and devices are shown in block diagram form to avoid unnecessarily obscuring various embodiments. Furthermore, various embodiments may be different from each other, but need not be exclusive. For example, specific shapes, configurations, and characteristics of an embodiment may be used or implemented in other embodiments without departing from the scope of the concepts of the present disclosure.

Unless otherwise specified, the illustrated embodiments should be understood as providing illustrative features of varying details of some ways in which the concepts of the present disclosure may be actually implemented. Therefore, unless otherwise specified, features, components, modules, layers, films, panels, regions, and/or aspects (hereinafter, individually or collectively referred to as "elements") of various embodiments may be otherwise combined, separated, interchanged, and/or rearranged without departing from the scope of the concepts of the present disclosure.

The use of cross-hatching and/or shading in the accompanying drawings is generally provided to clarify boundaries between adjacent elements. As such, the presence or absence of cross-hatching or shading does not imply or indicate any preference or requirement for specific materials, material properties, dimensions, proportions, commonalities between illustrated elements, and/or any other characteristics, attributes, and properties of the elements unless specified. Furthermore, in the accompanying drawings, sizes and relative sizes of elements may be exaggerated for clarity and/or descriptive purposes. When an embodiment is implemented in a different manner, a specific process order may be performed differently from the described order. For example, two consecutively described processes may be performed substantially simultaneously or performed in an order opposite to the described order. Furthermore, the same reference numerals denote the same elements.

When an element such as a layer is referred to as being "on", "connected to", or "coupled to" another element or layer, the element may be directly on, connected to, or coupled to the other element or layer, or intervening elements or layers may be present. However, when an element or layer is referred to as being "directly on", "directly connected to", or "directly coupled to" another element or layer, no intervening elements or layers are present. To this end, the term "connected" may refer to physical, electrical, and/or fluidic connection, with or without intervening elements. Furthermore, the DR1-axis, the DR2-axis, and the DR3-axis are not limited to three axes of a Cartesian coordinate system such as the x, y, and z-axes, and may be interpreted in a broader sense. For example, the DR1-axis, the DR2-axis, and the DR3-axis may be perpendicular to each other, or may represent different directions not perpendicular to each other. For the purposes of the present disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first", "second", etc. may be used herein to describe various types of elements, these elements should not be limited by these terms. These terms are used to distinguish one element from another element. Therefore, a first element discussed below may be termed a second element without departing from the teachings of the present disclosure.

Spatially relative terms, such as "beneath", "below", "directly below", "lower", "above", "upper", "over", "higher", "side" (e.g., as in "sidewall"), and the like, may be used for descriptive purposes and, thereby, to describe a relationship of one element to another element(s) as illustrated in the drawings. Spatially relative terms are intended to encompass different orientations of a device in use, operation, and/or manufacture in addition to the orientation depicted in the drawings. For example, when the device in the drawings is turned over, elements described as "below" or "beneath" other elements or features would be oriented "above" the other elements or features. Therefore, the exemplary term "below" may encompass both an orientation of above and below. Furthermore, the device may be otherwise oriented (e.g., rotated 90 degrees or at other orientations), and as such, the spatially relative descriptors used herein may also be interpreted accordingly.

The terminology used herein is for the purpose of describing particular embodiments only and is not intended to be limiting. As used herein, the singular forms include the plural forms as well, unless the context clearly indicates otherwise. Furthermore, the terms "comprises", "comprising", "includes", and/or "including", when used herein, specify the presence of stated features, integers, operations, elements, components, and/or groups thereof, but do not preclude the presence or addition of one or more other features, integers, operations, elements, components, and/or groups thereof. Furthermore, the terms "substantially", "about", and other similar terms used herein are used as terms of approximation and not as terms of degree, and as such, are used to account for inherent deviations in measured, calculated, and/or provided values recognized by a person having ordinary skill in the art.

Various embodiments are described below with reference to cross-sectional and/or exploded illustrations being schematic illustrations of idealized embodiments and/or intermediate structures. As such, variations from the shapes of the illustrations as a result, for example, of manufacturing techniques and/or tolerances, are to be expected. Therefore, embodiments disclosed herein should not be construed as limited to the particular shapes of regions illustrated herein but are to include deviations in shapes resulting, for example, from manufacturing. In this manner, regions illustrated in the drawings may be schematic in nature, and shapes of these regions may not reflect actual shapes of regions of a device, and as such, are not necessarily intended to be limiting.

As is customary in the field, some embodiments may be illustrated and described in the accompanying drawings in terms of functional blocks, units, and/or modules. A person having ordinary skill in the art will understand that these blocks, units, and/or modules are physically implemented by electronic (or optical) circuits such as logic circuits, discrete components, microprocessors, hard-wired circuits, memory elements, wiring connections, and the like formed using semiconductor-based manufacturing techniques or other manufacturing techniques. When blocks, units, and/or modules are implemented by a microprocessor or other similar hardware, they may be programmed and controlled using software (e.g., microcode) to perform various functions discussed herein, and may optionally be driven by firmware and/or software. Furthermore, each block, unit, and/or module may be implemented by dedicated hardware, or as a combination of dedicated hardware performing some functions and a processor (e.g., one or more programmed processors and associated circuitry) performing other functions. Furthermore, each block, unit, and/or module of some embodiments may be physically separated into two or more interacting and discrete blocks, units, and/or modules without departing from the scope of the concepts of the present disclosure. Furthermore, blocks, units, and/or modules of some embodiments may be physically combined into more complex blocks, units, and/or modules without departing from the scope of the concepts of the present disclosure.

Unless otherwise defined, all terms (including technical and scientific terms) used herein have the same meaning as commonly understood by a person having ordinary skill in the art to which the present disclosure belongs. Terms such as those defined in commonly used dictionaries should be interpreted as having a meaning consistent with their meaning in the context of the relevant art, and should not be interpreted in an idealized or overly formal sense unless explicitly defined herein.

Hereinafter, an optoelectronic semiconductor device 10 and an optoelectronic semiconductor device assembly 1 including the same according to a first embodiment of the present disclosure will be described.

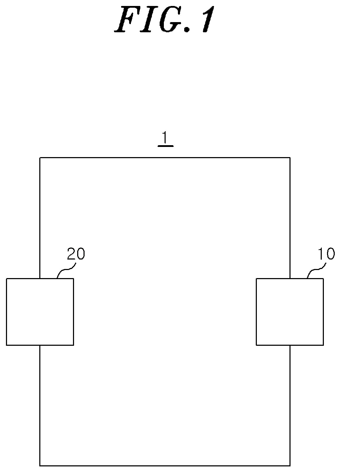

Referring to FIG. 1, the optoelectronic semiconductor device assembly 1 according to the first embodiment of the present disclosure may emit light. Furthermore, the optoelectronic semiconductor device assembly 1 may be mounted on a vehicle. As an example, such an optoelectronic semiconductor device assembly 1 may be disposed in an indoor lamp for a vehicle. As a more detailed example, the optoelectronic semiconductor device assembly 1 mounted on the vehicle may generate light to irradiate a driver's seat. Furthermore, an operation of the optoelectronic semiconductor device assembly 1 may be controlled according to an electrical signal. Furthermore, the optoelectronic semiconductor device assembly 1 may be controlled according to an external signal and driven in various ways. The optoelectronic semiconductor device assembly 1 may include the optoelectronic semiconductor device 10 and a power supply 20.

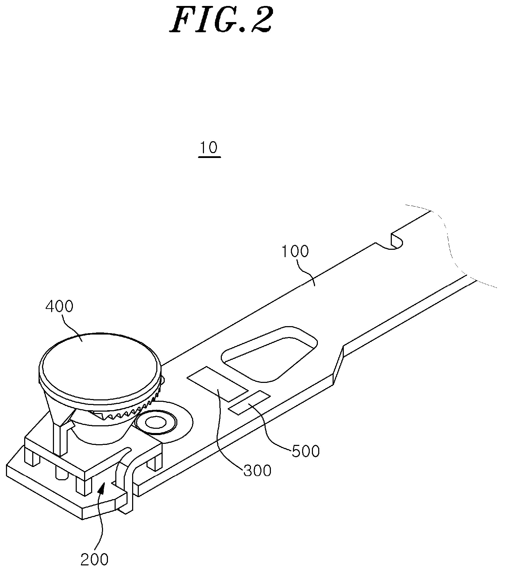

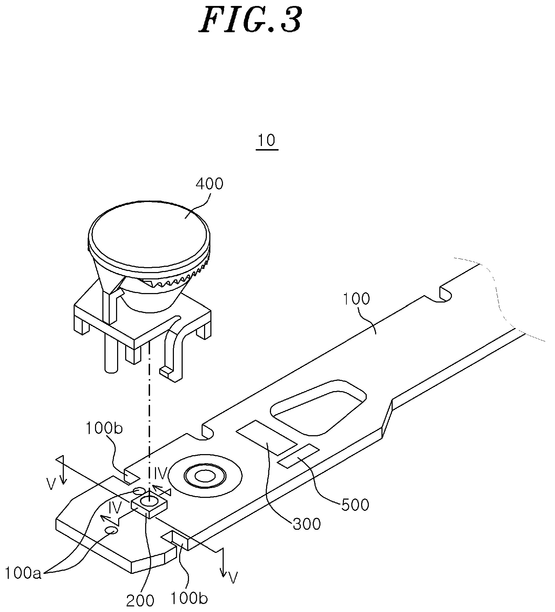

Further referring to FIGS. 2 and 3, the optoelectronic semiconductor device 10 may emit light. The optoelectronic semiconductor device 10 may be electrically connected to the power supply 20 and controlled according to an electrical signal. The optoelectronic semiconductor device 10 may be driven by an optoelectronic semiconductor device driving voltage supplied from the power supply 20 (not shown in FIGS. 2 and 3). The optoelectronic semiconductor device 10 may include a circuit board 100, a light emitting element 200, an auxiliary element 300, a refractor 400, and an outer resistor 500.

An electric circuit may be disposed on the circuit board 100. The circuit board 100 may support one or more of the light emitting element 200, the auxiliary element 300, the refractor 400, and the outer resistor 500. In one embodiment, the light emitting element 200, the auxiliary element 300, and the outer resistor 500 may be disposed on the circuit board 100 to be connected to the electric circuit. The electric circuit of the circuit board 100 may supply electricity to the light emitting element 200 and the auxiliary element 300. As an example, the circuit board 100 may be a printed circuit board (PCB) having an electric circuit printed thereon.

The circuit board 100 may extend in a longitudinal direction. Furthermore, the refractor 400 may be disposed on the circuit board 100. A groove to which the refractor 400 may be connected may be formed in the circuit board 100. As an example, a board through-hole 100a into which an insert 470 to be described later is inserted may be circularly formed in the circuit board 100, or a fastening hole 100b with which a fastener 480 to be described later engages may be formed at an edge of the circuit board 100.

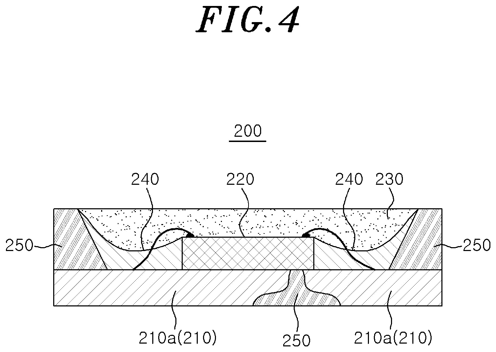

Further referring to FIG. 4, the light emitting element 200 may generate light. The light emitting element 200 may be supported by the circuit board 100 (not shown in FIG. 4). As an example, the light emitting element 200 may be disposed at both ends of the circuit board 100 in the longitudinal direction. In another embodiment, the light emitting element 200 may be electrically connected to the electric circuit and receive electricity from an external source through the electric circuit to generate light. In other words, the light emitting element 200 may receive power from the external power supply 20 to irradiate the outside with light. Such a light emitting element 200 may include a base substrate 210, a light emitting diode 220, a wavelength conversion layer 230, a first reflection layer 250, and a second reflection layer 240.

The light emitting diode 220, the wavelength conversion layer 230, the first reflection layer 240, and the second reflection layer 250 may be disposed in one region of the base substrate 210. An electrode part 210a electrically connectable to the external power supply 20 may be disposed on the base substrate 210. The light emitting diode 220 may be electrically connected to the power supply 20 through the electrode part 210a of the base substrate 210. Furthermore, the base substrate 210 may reflect a portion of light generated in the light emitting element 200. In other words, the base substrate 210 may reflect a portion of light generated in the light emitting diode 220 to improve luminous efficiency.

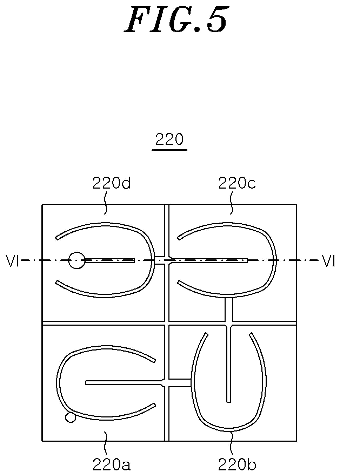

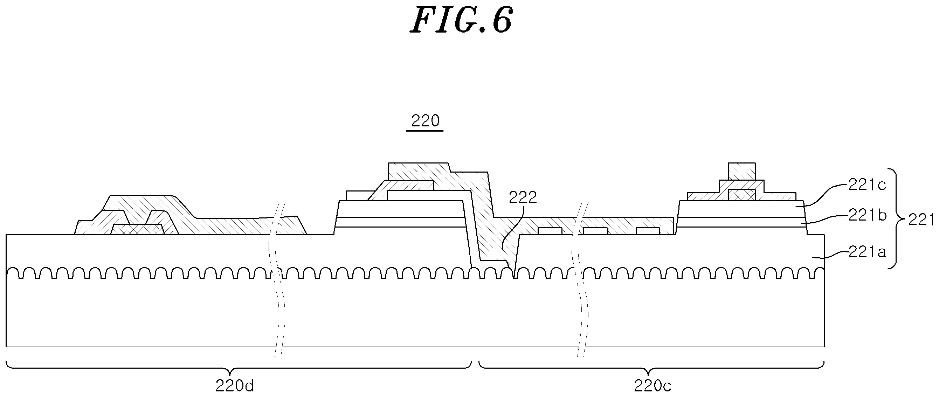

Further referring to FIGS. 5 to 6, the light emitting diode 220 may generate light when power from the external power supply 20 is applied. In other words, the light emitting diode 220 may be a light source element emitting light to the outside when a current is supplied. As an example, such a light emitting diode 220 may be a lateral chip. Such a light emitting diode 220 may include a plurality of light emitting cells 220a, 220b, 220c, and 220d. Each of the light emitting cells 220a, 220b, 220c, 220d may comprise two electrodes. As a more detailed example, the sum of the number of electrodes provided to the light emitting element 200 may be 8, and the number of electrodes provided to the circuit board 100 connected to the light emitting element 200 may be 2.In other words, a total number of electrodes formed on the light emitting element 200 may exceed the total number of electrodes provided to the circuit board 100 connected to the light emitting element 200.

The plurality of light emitting cells 220a, 220b, 220c, and 220d may be electrically connected to each other to form one light emitting diode 220. Such a plurality of light emitting cells 220a, 220b, 220c, and 220d may include a first light emitting cell 220a, a second light emitting cell 220b, a third light emitting cell 220c, and a fourth light emitting cell 220d. Light emitting layers formed inside respective light emitting cells 220a, 220b, 220c, and 220d may be disposed to be spaced apart from each other.

Furthermore, the first light emitting cell 220a, the second light emitting cell 220b, the third light emitting cell 220c, and the fourth light emitting cell 220d may be electrically connected in series to each other. As an example, the plurality of light emitting cells 220a, 220b, 220c, and 220d may be connected in series without sharing a base substrate like a sapphire layer. In another embodiment, the plurality of light emitting cells 220a, 220b, 220c, and 220d may share one base substrate, like a sapphire layer, to be integrally formed.

A current difference between the plurality of light emitting cells 220a, 220b, 220c, and 220d may be reduced through such series connection, such that light emission from the respective light emitting cells 220a, 220b, 220c, and 220d becomes uniform. In other words, light generated from the light emitting element 200 may be emitted with a uniform light distribution to increase luminous efficiency of the optoelectronic semiconductor device 10. Furthermore, light generated from the light emitting diode 220 may appear like light generated from one light emitting element 200. As an example, the plurality of light emitting cells 220a, 220b, 220c, and 220d may have a luminous efficiency ranging from 100 Im/W to 200 lm/W.

Heat generated in the plurality of light emitting cells 220a, 220b, 220c, and 220d may be uniformly dissipated without being concentrated in one portion. In other words, heat is uniformly emitted from the plurality of light emitting cells 220a, 220b, 220c, and 220d, preventing a heating concentration of the optoelectronic semiconductor device 10. Furthermore, driving of the light emitting diode 220 may be stabilized, improving reliability of the light emitting diode 220. Such a light emitting diode 220 may include a semiconductor stacked body 221 and a separation groove 222.

The semiconductor stacked body 221 may affect luminous efficiency, wavelength characteristics, and current distribution of the light emitting diode 220. As an example, the semiconductor stacked body 221 may be formed to emit blue light or ultraviolet (UV) light. The semiconductor stacked body 221 may include a lower semiconductor layer 221a, an active layer 221b, and an upper semiconductor layer 221c. Such a semiconductor stacked body 221 may be independently formed in the plurality of light emitting cells 220a, 220b, 220c, and 220d.

The first light emitting cell 220a, the second light emitting cell 220b, the third light emitting cell 220c, and the fourth light emitting cell 220d may be electrically connected to each other through connection electrodes. For example, the second light emitting cell 220b may be electrically connected to the first light emitting cell 220a through a first connection electrode. Furthermore, the third light emitting cell 220c may be electrically connected to the second light emitting cell 220b through a second connection electrode. Furthermore, the fourth light emitting cell 220d may be electrically connected to the third light emitting cell 220c through a third connection electrode.

As an example, a first upper semiconductor layer 221c-1 of the first light emitting cell 220a may be electrically connected to a second lower semiconductor layer 221a-2 of the second light emitting cell 220b. A second upper semiconductor layer 221c-2 of the second light emitting cell 220b may be electrically connected to a third lower semiconductor layer 221a-3 of the third light emitting cell 220c. A third upper semiconductor layer 221c-3 of the third light emitting cell 220c may be electrically connected to a fourth lower semiconductor layer 221a-4 of the fourth light emitting cell 220d. Furthermore, a first lower semiconductor layer 221a-1 of the first light emitting cell 220a may be electrically connected to the power supply 20, and a fourth upper semiconductor layer 221c-4 of the fourth light emitting cell 220d may be electrically connected to the power supply 20.

The plurality of light emitting cells may include respective separation grooves 222. The plurality of light emitting cells may include separation grooves 222 respectively formed between adjacent ones of the plurality of light emitting cells. The separation groove 222 may separate the first light emitting cell 220a, the second light emitting cell 220b, the third light emitting cell 220c, and the fourth light emitting cell 220d from each other. In other words, separation grooves 222 may separate the plurality of light emitting cells from each other. Such a separation groove 222 may prevent electrical interference between the respective light emitting cells 220a, 220b, 220c, and 220d. In other words, a current path may be separated. Furthermore, the separation groove 222 may be formed in the semiconductor stacked body 221 through a mesa process.

Turning back to FIG. 4, the wavelength conversion layer 230 may convert a wavelength of light emitted from the light emitting diode 220 into a different wavelength. In other words, the wavelength conversion layer 230 may absorb light emitted from the light emitting diode 220, convert the light into light of a different wavelength, and generate light having the converted wavelength. As an example, the wavelength conversion layer may absorb blue light or ultraviolet light emitted from the light emitting diode 220 to convert the absorbed light into yellow light, green light, or red light. In another embodiment, the converted light and light not affected by the wavelength conversion layer 230 in the light emitting diode 220 may be mixed to emit white light.

The first reflection layer 250 may extend upward from an edge of the base substrate 210. An accommodation space may be formed inside the light emitting element 200 by the first reflection layer 250. The light emitting diode 220 may be accommodated in the accommodation space. A height of the first reflection layer 250 may be equal to or greater than a height of the light emitting diode 220. Through this, the first reflection layer 250 may protect the light emitting diode 220 from external impact.

The second reflection layer 240 may be in contact with a side surface of the light emitting diode 220, or may be disposed on the base substrate 210 spaced apart from the light emitting diode. The second reflection layer 240 may cover one surface of the first reflection layer 250. The second reflection layer 240 may have a higher reflectance than the first reflection layer 250. The second reflection layer 240 may include a resin, like silicone, containing a reflective material, which may be at least one of alumina (Al2O3), titanium dioxide (TiO2), and barium sulfate (BaSO4). The reflective material may be dispersed in the resin.

The light emitting element 200 may generate light when a voltage greater than or equal to the light emitting element driving voltage is applied. The light emitting element driving voltage may be a voltage used by the light emitting element 200 to generate light according to a design specification of the light emitting element 200 out of the optoelectronic semiconductor device driving voltage when the optoelectronic semiconductor device driving voltage is applied from the external power supply 20. The light emitting element driving voltage of the light emitting element 200 may increase in proportion to the number of the plurality of light emitting cells 220a, 220b, 220c, and 220d of the light emitting diode 220. Since electrical energy of the auxiliary element applied voltage is consumed in the auxiliary element 300 as well as the light emitting element 200 in the optoelectronic semiconductor device 10, the light emitting element driving voltage applied to the light emitting element 200 may be equal to a voltage obtained by subtracting the auxiliary element applied voltage from the optoelectronic semiconductor device driving voltage applied from an external source. In other words, a current corresponding to a voltage obtained by subtracting the auxiliary element applied voltage from the optoelectronic semiconductor device driving voltage may flow through the light emitting element 200.

Furthermore, a difference between the optoelectronic semiconductor device driving voltage and the light emitting element driving voltage may be smaller than the light emitting element driving voltage. The difference between the optoelectronic semiconductor device driving voltage and the light emitting element driving voltage may be equal to or greater than 0.1 times the optoelectronic semiconductor device driving voltage and equal to or less than 0.5 times the optoelectronic semiconductor device driving voltage. The difference between a sum of the light emitting element driving voltage and the auxiliary element applied voltage and the optoelectronic semiconductor device driving voltage may be less than 5 V, and as a more detailed example, may be less than 2 V. For example, when the optoelectronic semiconductor device driving voltage is 13.5 V, the light emitting element driving voltage is 12 V, and the auxiliary element applied voltage is 1.5 V, a difference between the light emitting element driving voltage and the optoelectronic semiconductor device driving voltage may be 1.5 V, which is less than 2 V.

The light emitting element 200 may be driven at a relatively high voltage and a relatively low current. As an example, the light emitting element 200 may generate light to a designed specification when a voltage of 8.5 V to 13 V is applied. As the light emitting element 200 is driven at a high voltage, use of unnecessary resistors in the optoelectronic semiconductor device 10 may be reduced. As the use of resistors is reduced, a manufacturing cost of the circuit board 100 may be reduced, and an area of the circuit board 100 may be reduced, miniaturizing an overall size of the optoelectronic semiconductor device 10.

The light emitting element 200 may be operable to allow a current ranging from 10 mA to 50 mA to flow when the light emitting element driving voltage is applied. As an example, the light emitting element 200 may emit light of a designed specification when a current of 25 mA flows. As the light emitting element 200 is driven at a low current, a current capacity required for the circuit board 100 may be reduced, and the manufacturing cost of the circuit board 100 may be reduced.

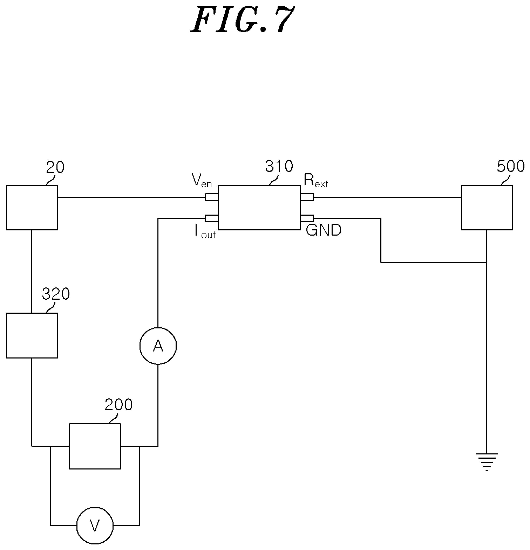

Further referring to FIG. 7, the auxiliary element 300 may stabilize a circuit by controlling a current or a voltage. The auxiliary element 300 may be disposed and supported on the circuit board 100. The auxiliary element 300 may be electrically connected to the light emitting element 200 through the circuit board 100. The auxiliary element 300 may be configured to receive the auxiliary element applied voltage. Such an auxiliary element 300 may include at least one of the IC chip 310 and the inner resistor 320.

The IC chip 310 may output a stable voltage by regulating an input voltage applied from the external power supply 20. The IC chip 310 may be electrically connected to the external power supply 20. The IC chip 310 may be configured to regulate a voltage applied from the external power supply 20 and output a regulated output voltage. In other words, the IC chip 310 may change a voltage level of the external power supply 20 to a required voltage level, and output the changed voltage. Furthermore, the IC chip 310 may filter a voltage fluctuation of the power supply 20 to stably maintain an output voltage. As an example, the regulated output voltage of the IC chip 310 may be smaller than the light emitting element driving voltage. In another embodiment, when the light emitting element driving voltage is equal to the optoelectronic semiconductor device driving voltage, the IC chip 310 may be omitted. Such an IC chip 310 may be a regulator IC chip.

The inner resistor 320 may limit an amount of current flowing through a circuit. The inner resistor 320 may be electrically connected to the light emitting element 200. The inner resistor 320 may adjust a voltage applied to the light emitting element 200. In other words, the optoelectronic semiconductor device driving voltage may be equal to a sum of the regulated output voltage of the IC chip 310, the light emitting element driving voltage, and a voltage drop across the inner resistor 320. As an example, a voltage applied to the inner resistor 320 may be lower than the light emitting element driving voltage. In another embodiment, when the light emitting element 200 and the IC chip 310 are configured such that a sum of the light emitting element driving voltage and the regulated output voltage of the IC chip 310 is equal to the optoelectronic semiconductor device driving voltage, the inner resistor 320 may be omitted.

The auxiliary element applied voltage may be a voltage applied to the auxiliary element 300 out of the optoelectronic semiconductor device driving voltage applied from an external source. A sum of driving voltages applied to driving the light emitting element 200 may be greater than the auxiliary element applied voltage. In other words, the light emitting element driving voltage may be greater than the auxiliary element applied voltage. As an example, a sum of the light emitting element driving voltage and the auxiliary element applied voltage may range from 8 V to 16 V.

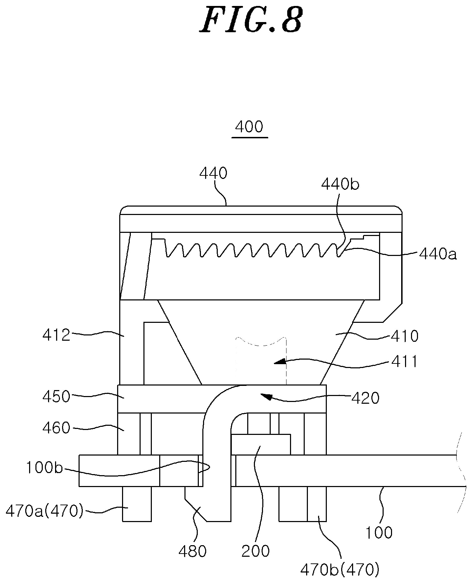

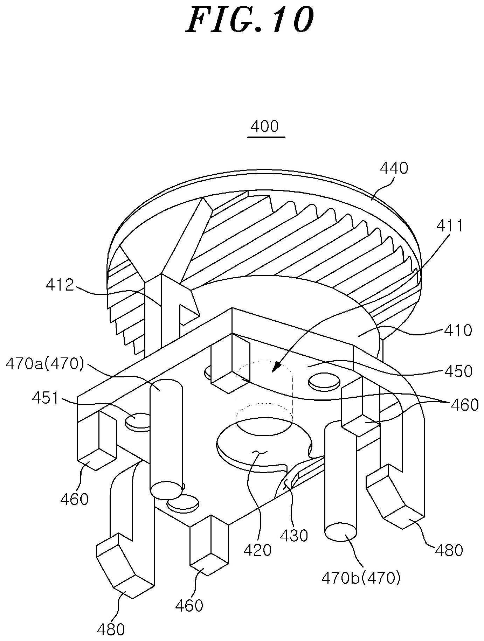

Further referring to FIGS. 8 and 10, the refractor 400 may refract light generated from the light emitting element 200. The refractor 400 may be connected to the circuit board 100. As an example, the refractor 400 may be disposed on an outer side of the light emitting element 200. When a plurality of optoelectronic semiconductor devices 10 are provided, the refractor 400 disposed on an outer side of the light emitting element 200 may refract light such that the plurality of optoelectronic semiconductor devices 10 do not interfere each other. Such a refractor 400 may be disposed at both ends of the circuit board 100 along the longitudinal direction. The refractor 400 may refract light generated from the light emitting element 200 toward the center of the circuit board 100. As an example, when the optoelectronic semiconductor device 10 is used as an indoor lamp for a front seat of a vehicle, the refractor 400 may refract light toward a driver's seat or a passenger seat. The refractor 400 may include a body 410, a light-incident hole 420, an auxiliary hole 430, a lens 440, a flange 450, a spacer 460, an insert 470, and a fastener 480.

The body 410 may support the lens 440 and the flange 450. The body 410 may be located at a center of the flange 450. As an example, the body 410 may have a conical shape. As a more detailed example, the body 410 may have a tapered shape increasing in diameter from a lower side to an upper side. A window 411 and a supporting member 412 may be provided in such a body 410.

The window 411 may refract and transmit light having passed through the light-incident hole 420. A cross-sectional surface of the window 411 may face the same direction as the light-incident hole 420. In other words, when light passes through the light-incident hole 420, the light may reach the window 411. A diameter of the cross-sectional surface of the window 411 may be 60% to 80% of a diameter of a cross section of the light-incident hole 420. Through this, light generated from the light emitting element 200 may sequentially enter the light-incident hole 420 and window 411. Furthermore, luminance of a target area preset by a user may be increased. Such a window 411 may be formed in an inner center of the body 410.

A curved surface having a concave curvature may be formed on the innermost side of the window 411. In other words, a center of the curved surface of the window 411 may be formed lower than an edge of the curved surface of the window 411, such that the inner center of the window 411 has a concave curved structure. As an example, the window 411 may have a concave curved surface to have a concave lens shape. In other words, when viewed in a longitudinal cross section crossing the center of the window 411, a cross section of the window 411 may have a downwardly concave shape. In other words, an upper surface of the window 411 may have a concave curved structure. Furthermore, a center of a curved surface of the window 411 is lower than an edge of the curved surface of the window 411. A height from a lowermost side of the window 411 to an innermost side of the concave curved structure may be 5% to 30% of a height from the lowermost side of the window 411 to an outermost side of the concave curved structure. In other words, the height from a lower surface of the window 411 to the center of the curved surface of the window 411 may be 5% to 30% of the height from the lower surface of the window 411 to the edge of the curved surface of the window 411. Through this, light entering through the window 411 may be refracted to a center region to increase luminance.

The supporting member 412 may support the lens 440. In one embodiment, the supporting member 412 may support the lens 440 such that the lens 440 is spaced apart from the body 410. A separation distance between the lens 440 and the body 410 may be 40% to 70% of the height of the body 410. Through this, a sufficient refraction distance may be secured allowing light incident from the light emitting element 200 to be refracted, increasing luminance of the optoelectronic semiconductor device 10.

Such a supporting member 412 may extend upward from an upper surface of the flange 450. As an example, the supporting member 412 may be connected to an edge of the lens 440. As the supporting member 412 is connected to the flange 450 and supports the lens 440, the supporting member 412 may improve structural stability of the lens 440. Furthermore, a width of the supporting member 412 may become wider closer to the lens 440. In other words, the width of the supporting member 412 may have a shape widening farther from the flange 450. A maximum width of the supporting member 412 may be 40% to 60% of the maximum width of the flange 450. Through this, distortion of light emitted from the light emitting element 200 by the supporting member 412 may be reduced.

One region of the supporting member 412 may be formed to be spaced apart from the body 410. As an example, the one region of the supporting member 412 may be formed to be connected solely to the flange 450. A separation distance between the supporting member 412 and the body 410 may widen closer to the light emitting element 200. In other words, the separation distance between the supporting member 412 and the body 410 may widen closer to the flange 450. A maximum separation distance between the one region of the supporting member 412 and the body 410 may be 0.4 to 0.7 times the diameter of the light-incident hole 420. Through this, refraction of light entering the refractor 400 by the supporting member 412 may be reduced. Furthermore, luminance of a target area preset by a user may be increased.

The light-incident hole 420 may guide light to the lens 440. In other words, the light-incident hole 420 may provide an optical path allowing light emitted from the light emitting element 200 to pass through the light-incident hole 420 to reach the lens 440. As an example, the light-incident hole 420 may be formed as a circular through-hole in the flange 450. Furthermore, the light-incident hole 420 may be connected to the auxiliary hole 430.

The auxiliary hole 430 may provide an optical path guiding light. In other words, the auxiliary hole 430 may provide an optical path allowing light emitted from the light emitting element 200 to travel through the auxiliary hole 430. As an example, the auxiliary hole 430 may be formed as a semi-elliptical groove in the flange 450. The auxiliary hole 430 may have an opening formed facing an inward direction of the optoelectronic semiconductor device 10. The auxiliary hole 430 may become wider toward an outer side of the refractor 400. A height of the auxiliary hole 430 may be 15% to 25% of the height of the body 410. Furthermore, the height of the auxiliary hole 430 may be 40% to 70% a height of the flange 450. Through this, a target optical path preset by a user may be maintained. Furthermore, structural stability of the refractor 400 may be maintained.

Such an auxiliary hole 430 may be connected to the light-incident hole 420. An outermost width of the auxiliary hole 430 may be 1.2 to 1.4 times wider than the width of the light-incident hole 420. Through this, light emitted from the light emitting element 200 may be refracted toward an inner surface of the optoelectronic semiconductor device 10. The auxiliary hole 430 and the light-incident hole 420 may contact each other at an innermost side of the auxiliary hole 430. In a region where the auxiliary hole 430 and the light-incident hole 420 contact each other, the auxiliary hole 430 may have a minimum width. The minimum width of the auxiliary hole 430 may have a width of 30% to 40% with respect to a maximum width of the auxiliary hole 430. Through this, light emitted from the light emitting element 200 may be guided and refracted toward an outside of the optoelectronic semiconductor device 10. A minor axis width of the auxiliary hole 430 may have a width of 20% to 30% with respect to the width of the light-incident hole 420. Through this, an optical path may be adjusted such that the light-incident hole 420 serves as a primary incident surface for light.

The lens 440 may refract light generated from the light emitting element 200. In other words, light guided from the light-incident hole 420 may be refracted by the lens 440. An upper surface of the lens 440 may be flat. The upper surface of such a lens 440 may be circular. Furthermore, a plurality of protrusions may be formed on a lower surface of the lens 440. A rounded portion having a curvature may be formed between adjacent protrusions. Due to the curvature of the rounded portion formed between the protrusions, an optical loss of light generated from the light emitting element 200 may be reduced. As an example, when the lens 440 is installed in an indoor lamp for a front seat of a vehicle, light is refracted by the protrusions, allowing light to be guided to a driver's seat or a passenger seat without separately adjusting a viewing angle. The protrusions may have at least one inclined surface with respect to the flat upper surface. Such protrusions may have a first protrusion surface 440a and a second protrusion surface 440b.

The first protrusion surface 440a may be formed as an inclined surface. An inclination of the first protrusion surface 440a may be inclined toward the center in the longitudinal direction of the circuit board 100. More specifically, when the light emitting element 200 is located at a distance D1 from a center of the circuit board 100, a normal vector of the inclined first protrusion surface 440a will intersect the circuit board 100 at a distance D2 < D1. When the lens 440 is used as an indoor lamp for a vehicle, light may be guided to a driver's seat or a passenger seat by the first protrusion surface 440a. The inclined surface of the first protrusion surface 440a may have an inclination of 50 degrees to 60 degrees with respect to a plane of the lens 440.

The second protrusion surface 440b may be formed as a non-inclined surface. In other words, the second protrusion surface 440b may extend in a vertical direction. The second protrusion surface 440b may be formed at an angle greater than 90 degrees with respect to the circuit board 100 extending in the longitudinal direction. An inclined surface of the second protrusion surface 440b may have an inclined surface inclined at an angle of 92 degrees to 96 degrees with respect to the plane of the lens 440.

The first protrusion surface 440a and the second protrusion surface 440b may have different inclinations. For example, the first protrusion surface 440a and the second protrusion surface 440b may have inclinations in opposite directions. A lower end of the second protrusion surface 440b may be connected to a lower end of the first protrusion surface 440a. In other words, the lower end of the first protrusion surface 440a extending with an inclination and the lower end of the second protrusion surface 440b extending with an inclination in an opposite direction may contact and be connected to each other.

A region where the lower end of the first protrusion surface 440a and the lower end of the second protrusion surface 440b contact each other may have a lower protrusion curvature. Furthermore, a region where an upper end of the first protrusion surface 440a of a first protrusion and an upper end of the second protrusion surface 440b of a second protrusion adjacent to the first protrusion contact each other may have an upper protrusion curvature. The lower protrusion curvature may be larger than the upper protrusion curvature. A lower protrusion radius of curvature may be smaller than an upper protrusion radius of curvature. The upper protrusion radius of curvature may be 2.4 to 3 times the lower protrusion radius of curvature. The upper protrusion radius of curvature may be 25% to 35% of a vertical height of the protrusions formed on the lens 440. The lower protrusion radius of curvature may be 8% to 14% of a vertical height of the protrusions formed on the lens 440. By setting the radius of curvature of an upper protrusion to be larger than the radius of curvature of a lower protrusion, extraction efficiency of light heading toward an upper end of the refractor 400 may be increased, and luminous intensity may be increased by strengthening light intensity.

The flange 450 may be connected to the body 410 at a lower side of the body 410. The flange 450 may support at least one of the spacer 460, the insert 470, and the fastener 480. Furthermore, a plurality of grooves 451 may be formed in a lower surface of such a flange 450. The groove 451 may guide an arrangement position of the refractor 400 such that an optical axis of the light emitting element 200 is aligned parallel with the window 411. As an example, the groove 451 may be formed in the lower surface of the flange 450, and may be a curved groove having an increasing height toward a center. In other words, a groove 451 being a concave curved groove may be formed in the flange 450. A plurality of such grooves 451 may be provided. For example, four grooves 451 may be provided.

The spacer 460 may space the flange 450 apart from the circuit board 100 such that a space is formed between the circuit board 100 and the refractor 400. The spacer 460 may extend from the flange 450 to be in close contact with one surface of the circuit board 100. The spacer 460 may extend downward from a lower surface of the flange 450. A height of the spacer 460 may be 0.9 to 1.2 times the height of the flange 450. Through this, a sufficient distance for refracting light emitted from the light emitting element 200 may be secured. Such a spacer 460 may be formed as a rectangular parallelepiped. Furthermore, a plurality of spacers 460 may be provided. For example, three or more spacers 460 may be provided.

The insert 470 may extend from the flange 450 to be disposed to pass through the circuit board 100. The insert 470 may extend downward from the lower surface of the flange 450. Such an insert 470 may have a cylindrical shape. Furthermore, the insert 470 may pass through the board through-hole 100a formed in the circuit board 100. The insert 470 may include a first insert 470a and a second insert 470b.

The first insert 470a may pass through a hole formed in the circuit board 100 to fix the refractor 400 to the circuit board 100. As an example, the first insert 470a may be disposed between the plurality of spacers 460 and at an edge of the flange 450. Furthermore, the first insert 470a may pass through board through-holes 100a formed at both ends of the circuit board 100 extending in the longitudinal direction. A height of the first insert 470a may be substantially equal to a sum of a thickness of the circuit board 100 and a thickness of the spacer 460. The height of the first insert 470a may have a height 2 to 2.5 times higher than the height of the spacer 460. Through this, the refractor 400 may be stably inserted into the circuit board 100.

The second insert 470b may be disposed on the flange 450 so that a user may recognize an installation direction of the refractor 400. As an example, the second insert 470b may be disposed between the light-incident hole 420 and the fastener 480. A diameter of the second insert 470b may be smaller than a diameter of the first insert 470a.

The fastener 480 may be selectively connected to the circuit board 100. The fastener 480 may be disposed on both sides of the refractor 400 in another direction crossing longitudinal direction in which the circuit board 100 extends. As the fastener 480 engages with the fastening hole 100b formed at an edge of the circuit board 100, the refractor 400 may be connected to the circuit board 100. In other words, as the fastener 480 is connected to the edge of the circuit board 100, the refractor 400 may be fixed to the circuit board 100. A plurality of such fasteners 480 may be formed. As a more detailed example, two or more fasteners 480 may be provided.

An upper portion of the fastener 480 may extend from the flange 450 in a bent shape. In other words, the upper portion of the fastener 480 may have a smoothly bent shape. As a corner of the fastener 480 is smoothly formed, stress concentrated on the fastener 480 is distributed, improving mechanical strength. Furthermore, a hook may be formed at a lower end of the fastener 480. When there are two or more fasteners 480, hooks may extend in the same direction. Furthermore, at least one of the hooks of the fastener 480 may extend in a direction opposite to an inclination direction of the first protrusion surface 440a or an inclination direction of the second protrusion surface 440b. A lower end of such a fastener 480 may engage with the fastening hole 100b formed in the circuit board 100, allowing the refractor 400 to be fixed to the circuit board 100. A height of the fastener 480 may be 1.1 to 1.5 times the height of the body 410. Through this, the refractor 400 may be stably disposed on the circuit board 100.

An output current of the IC chip 310 may be determined by the outer resistor 500 according to an internal reference voltage of the IC chip 310. In other words, the output current of the IC chip 310 may be determined according to a magnitude of a resistance value of the outer resistor 500. A user may adjust a driving condition of the light emitting element 200 by adjusting the outer resistor 500. Such an outer resistor 500 may be electrically connected between the IC chip 310 and a ground (GND).

The power supply 20 may supply power to the optoelectronic semiconductor device 10. Furthermore, the power supply 20 may be electrically connected to the optoelectronic semiconductor device 10. The power supply 20 may apply an optoelectronic semiconductor device driving voltage. As an example, the optoelectronic semiconductor device driving voltage may be greater than 7 V and less than 20 V. As a more detailed example, the optoelectronic semiconductor device driving voltage may be 13.5 V. Such a power supply 20 may be a battery of an automobile. For example, the power supply 20 may be an automobile battery supplying a voltage of 12 V or more and 18 V or less. A difference between a voltage supplied from the power supply 20 and the optoelectronic semiconductor device driving voltage may be less than 50% of the voltage supplied from the power supply 20. As a more detailed example, the difference between the power supply 20 and the optoelectronic semiconductor device driving voltage may be 5% to 40% of the voltage supplied from the power supply 20. Through this, a voltage drop from the power supply 20 may be reduced, improving reliability of the optoelectronic semiconductor device 10.

Referring again to FIG. 7, the power supply 20 may be electrically connected to the light emitting element 200, the inner resistor 320, the IC chip 310, and the outer resistor 500. The light emitting element 200 may be driven by a light emitting element driving voltage applied from the power supply 20, and the voltage applied to the light emitting element 200 may be measured by a voltmeter V.

The IC chip 310 may be a regulator IC chip. Ven may be an enable voltage applied to an enable terminal of the IC chip 310 to activate the IC chip 310. Iout may be an output current output from an output terminal of the IC chip 310, and Iout may be measured by an ammeter A. Rext may be an external resistor electrically connected to the output terminal of the IC chip 310. The outer resistor 500 may be provided to set or adjust an output current or an output voltage of the IC chip 310. GND may be a ground node that provides a reference potential of the circuit.

Although the embodiments of the present disclosure have been described as specific embodiments, these are merely examples. The present disclosure is not limited to the above, and should be interpreted as having the broadest scope according to the technical idea disclosed in the present specification. Those skilled in the art may combine/substitute the disclosed embodiments to implement a pattern of a shape not disclosed herein, but this also does not depart from the scope of the present disclosure. In addition, those skilled in the art may easily change or modify the disclosed embodiments based on the present specification, and it is clear that such changes or modifications also fall within the scope of the present disclosure.

## Claims

1. An optoelectronic semiconductor device assembly, comprising:
an optoelectronic semiconductor device; and
a power supply configured to supply power to the optoelectronic semiconductor device,
wherein the optoelectronic semiconductor device comprises:
a circuit board electrically connected to the power supply;
a light emitting element disposed on the circuit board and electrically connected to the power supply through the circuit board, the light emitting element being configured to generate light when a predetermined light emitting element driving voltage is applied to the light emitting element through the circuit board; and
an auxiliary element electrically connected to the circuit board and configured to be applied with a predetermined auxiliary element applied voltage from the power supply through the circuit board when the light emitting element driving voltage is applied to the light emitting element by the power supply,
wherein the light emitting element driving voltage is greater than the auxiliary element applied voltage.

2. The optoelectronic semiconductor device assembly of claim 1, wherein when the light emitting element driving voltage is applied to the light emitting element, a driving voltage applied from an external source to drive the optoelectronic semiconductor device is defined as an optoelectronic semiconductor device driving voltage, and a difference between the optoelectronic semiconductor device driving voltage and the light emitting element driving voltage is equal to or greater than 0.1 times the optoelectronic semiconductor device driving voltage and equal to or less than 0.5 times the optoelectronic semiconductor device driving voltage.

3. The optoelectronic semiconductor device assembly of claim 2, wherein the optoelectronic semiconductor device driving voltage ranges from 12 V to 18 V.

4. The optoelectronic semiconductor device assembly of claim 1, wherein, when the light emitting element driving voltage is applied, a current ranging from 10 mA to 50 mA flows through the light emitting element.

5. The optoelectronic semiconductor device assembly of claim 1, wherein the light emitting element has a luminous efficiency ranging from 100 lm/W to 200 Im/W.

6. The optoelectronic semiconductor device assembly of claim 1, wherein the light emitting element comprises a plurality of light emitting cells, and the plurality of light emitting cells are connected in series.

7. The optoelectronic semiconductor device assembly of claim 6, wherein separation grooves are, respectively, formed between adjacent ones of the plurality of light emitting cells to separate the adjacent ones.

8. The optoelectronic semiconductor device assembly of claim 6, wherein a total number of electrodes of the light emitting element is greater than a total number of electrodes of the circuit board connected with the light emitting element.

9. The optoelectronic semiconductor device assembly of claim 6, wherein the plurality of light emitting cells comprise:
a first light emitting cell;
a second light emitting cell electrically connected to the first light emitting cell through a first connection electrode;
a third light emitting cell electrically connected to the second light emitting cell through a second connection electrode; and
a fourth light emitting cell electrically connected to the third light emitting cell through a third connection electrode.

10. The optoelectronic semiconductor device assembly of claim 9, wherein the first light emitting cell and the fourth light emitting cell are electrically connected to the power supply.

11. The optoelectronic semiconductor device assembly of claim 1, wherein the light emitting element comprises:
a base substrate;
a light emitting diode configured to generate light; and
a first reflection layer extending upward from an edge of the base substrate.

12. The optoelectronic semiconductor device assembly of claim 11, wherein a height of the first reflection layer is equal to or greater than a height of the light emitting diode.

13. The optoelectronic semiconductor device assembly of claim 12, wherein the light emitting element further comprises a second reflection layer in contact with a side surface of the light emitting diode, and a reflectance of the second reflection layer is greater than that of the first reflection layer.

14. The optoelectronic semiconductor device assembly of claim 13, wherein the second reflection layer comprises at least one of silicone, alumina (Al₂O₃), titanium dioxide (TiO₂), and barium sulfate (BaSO₄).

15. The optoelectronic semiconductor device assembly of claim 11, wherein the base substrate is configured to reflect a portion of the light generated from the light emitting element.
